# EUROPÄISCHE PATENTANMELDUNG

(11) **EP 4 835 361 A1**
(43) Veröffentlichungstag der Anmeldung: **04.11.2026**
(21) Anmeldenummer: 25173290.5
(22) Anmeldetag: 29.04.2025
(51) Int. Cl.: F24D 18/00, H10N 10/13, F24D 19/00, F24H 9/00, F24F 5/00, F24D 101/60

(54) **HEIZSYSTEM**

(71) Anmelder: Coptimizer GmbH, 1030 Wien (AT)
(72) Erfinder: Kainer, Ali, 7443 Rattersdorf (AT); Gruber, Adrian, 7444 Mannersdorf an der Rabnitz (AT); Gruber, Markus, 1160 Wien (AT)
(74) Vertreter: Patentanwaltskanzlei Matschnig & Forsthuber OG

(57) **Zusammenfassung**

Die Erfindung betrifft ein Heizsystem (1), umfassend zumindest einen an einer Gebäudewand (2) montierten Heizkörper (3) zur Führung eines Fluids (4), insbesondere Heizwassers, wobei der Heizkörper (3) eine im Wesentlichen vertikal orientierte Vorderseite (3a) sowie eine der Vorderseite (3a) abgewandte vertikal orientierte Rückseite (3b) aufweist, wobei die Rückseite (3b) der Gebäudewand (2) zugewandt ist, wobei an der Oberfläche des Heizkörpers (3) zumindest eine Energiewandlungseinheit (5) angeordnet ist, wobei die zumindest eine Energiewandlungseinheit (5) einen thermoelektrischen Generator (5b) mit einer ersten Kontaktfläche (5b') und einer gegenüberliegenden zweiten Kontaktfläche (5b") aufweist, wobei die zumindest eine Energiewandlungseinheit (5) einen zur Luftdurchströmung eingerichteten Kühlkörper (5d) aufweist.

## Beschreibung

Die Erfindung betrifft ein Heizsystem, umfassend Heizsystem, umfassend zumindest einen an einer Gebäudewand montierten Heizkörper zur Führung eines Fluids, insbesondere Heizwassers, wobei der Heizkörper eine im Wesentlichen vertikal orientierte Vorderseite sowie eine der Vorderseite abgewandte vertikal orientierte Rückseite aufweist, wobei die Rückseite der Gebäudewand zugewandt ist, wobei an der Oberfläche des Heizkörpers zumindest eine Energiewandlungseinheit angeordnet ist, wobei die zumindest eine Energiewandlungseinheit einen thermoelektrischen Generator mit einer ersten Kontaktfläche und einer gegenüberliegenden zweiten Kontaktfläche aufweist, wobei die zumindest eine Energiewandlungseinheit einen zur Luftdurchströmung eingerichteten Kühlkörper aufweist, der mit der zweiten Kontaktfläche des thermoelektrischen Generators über eine zweite flächige Wärmeleitverbindung thermisch verbunden ist, um einen Wärmeaustausch der zweiten Kontaktfläche mit der Umgebungsluft des Kühlkörpers zu ermöglichen, wobei die erste Kontaktfläche des thermoelektrischen Generators über eine erste flächige Wärmeleitverbindung mit dem Heizkörper in thermischen Kontakt steht, sodass durch den thermoelektrischen Generator eine Temperaturdifferenz zwischen der ersten Kontaktfläche und der zweiten Kontaktfläche unter Ausnutzung des Seebeck-Effekts in elektrische Energie wandelbar ist.

Die meisten bekannten bestehenden Systeme zur Verbesserung des Wärmeaustausches von Heizkörpern mit ihrer Umgebung benötigen eine externe Spannungsversorgung von typischerweise 230V. Die Montage sowie der Anschluss solcher Systeme sind oftmals schwierig, da üblicherweise keine Steckdosen in der Nähe von Heizkörpern situiert sind. Will man diese nachrüsten sind einerseits Stemm- und Sanierungsmaßnahmen erforderlich, andererseits handelt es sich um einen Eingriff in das Bestandsobjekt - was die Durchführung einer erneuten elektrischen Prüfung und die Herausgabe eines neuen Elektro-Befunds erforderlich macht. Dies hat umfangreiche Kosten zur Folge.

Alternativ dazu können bestehende Heizkörper auch einfach ausgetauscht und durch Heizkörper mit vergrößerter Wärmetauschfläche ersetzt werden. Damit ist allerdings ein hydraulischer Eingriff (Entleeren, aufbereitetes Heizungswasser nachfüllen etc.) verbunden, der wiederum bedeutende Kosten verursacht. Hinzu kommt, dass es in vielen Einbausituationen durch die gegebenen räumlichen Umstände nicht möglich ist, Heizkörper mit vergrößerter Wärmetauschfläche einzusetzen.

Zudem wurden aus dem Stand der Technik ebenso Heizsysteme bekannt, bei denen versucht wird mittels eines Lüfters die Wärmeaustauschrate des Heizkörpers mit der Umgebung zu erhöhen. Eine Herausforderung bei solchen Systemen besteht darin, ein System zu schaffen, das robust und energieeffizient ist und gleichzeitig einfach montiert werden kann.

Eine Aufgabe der Erfindung besteht daher darin ein Heizsystem eingangs genannter Art zu schaffen, welches die Nachteile des Standes der Technik überwindet. Diese Aufgabe wird mit dem besagten Heizsystem gelöst, bei welchem erfindungsgemäß die erste flächige Wärmeleitverbindung eine metallische Wärmeverteilplatte aufweist, die mit einer ersten Seite flächig an der Vorderseite des Heizkörpers angeordnet ist, wobei durch eine der ersten Seite gegenüberliegenden zweiten Seite der Wärmeverteilplatte ein von der Vorderseite des Heizkörpers abgewandter ebener Wärmeleitbereich ausbildet wird, wobei die erste Kontaktfläche des thermoelektrischen Generators die Wärmeverteilplatte an der zweiten Seite an dem Wärmeleitbereich thermisch kontaktiert, wobei die erste Kontaktfläche des thermoelektrischen Generators die Fläche der zweiten Seite der Wärmeverteilplatte flächig kontaktiert, wobei Fläche der Wärmeverteilplatte größer ist als die ersten Kontaktfläche des thermoelektrischen Generators.

Durch die Erfindung ist eine robuste und rasche Montage des Heizsystems möglich. Durch den Einsatz der metallischen Wärmeverteilplatte wird ein ebener Bereich geschaffen, an dem thermoelektrische Generatoren effizient angebunden und mechanisch gleichmäßig belastet werden, wodurch die Gefahr von Bruch reduziert wird. Der Wärmeleitbereich ist ein Bereich der Wärmeverteilplatte, der zur Kontaktierung eines thermoelektrischen Generators vorgesehen bzw. geeignet ist.

Natürlich können eine wärmeleitfördernde Verbindungen wie Wärmeleitpasten angebracht werden, um den Wärmeübergang zwischen Wärmeverteilplatte und Vorderseite des Heizkörpers zu verbessern. Es kann vorgesehen sein, dass die erste Kontaktfläche des thermoelektrischen Generators die Fläche der zweiten Seite der Wärmeverteilplatte sogar vollflächig kontaktiert. Unter dem Ausdruck "vollflächig kontaktieren" wird verstanden, dass zumindest 70%, vorzugsweise mindestens 90%, insbesondere 100% der betreffenden Flächen einander kontaktieren.

Das Heizsystem kann auch zum Kühlen eingesetzt werden. Wenn die Temperaturen z.B. im Sommer sehr hoch sind, und Wasser in der Leitung der Heizkörper kühler als Lufttemperatur im Raum ist, so kann plötzlich im Umkehr zu dem Heizbetrieb der Heizkörper die kühle Seite des thermoelektrischen Generators versorgen und die Umgebungsluft seine warme Seite, da der Energiegewinnungsprozess im thermoelektrischen Generator so konfiguriert werden kann, dass dieser bloß eine Temperaturdifferenz zwischen den beiden Seiten benötigt, und zwar unabhängig von der Richtung.

Durch die Wärmeverteilplatte wird zudem eine ebene standardisierbare Montagefläche für Anbringung der Energiewandlungseinheit geschaffen. Der Heizkörper kann daher an seiner Oberfläche gerippt sein oder andere unebenen Formen aufweisen, ohne dass dabei die Montage eingeschränkt wird. Die Wärmeverteilplatte sorgt für einen guten Wärmeübergang von dem Heizkörper hin zu der ersten Kontaktfläche des thermoelektrischen Generators. Insbesondere kann die Wärmeverteilplatte eine glatte Oberfläche aufweisen, an der Energiewandlungseinheit bündig und vollflächig aufliegt. Dies hat thermische sowie mechanische Vorteile, da Energiewandlungseinheit an der angreifenden Seite eine keramische Oberfläche aufweist, die meist spröde ist und bei Druck auf Unebenheiten brechen kann. Der Temperaturgradient der einzelnen thermoelektrischen Generatoren (im Nachfolgenden auch Kurz "TEG" genannt) ist homogener und verbessert bzw. stellt einen Leistungsabgleich her. TEGs haben auf beiden Betriebsseiten häufig keramische Oberflächen. Der thermische Kontakt von TEGs wird durch einen Anpressdruck auf Oberflächen begünstigt. Sind Oberflächen zu rau oder uneben, können die Keramikoberflächen beim Anpressen zu Bruch gehen. Durch die Wärmeverteilplatte wird eine homogene geeignete Oberfläche für den Einsatz von TEGs auf Heizkörperoberflächen projiziert. Die mech. Belastung wird minimiert. Durch die verbesserte Oberfläche wird die thermische Verbindung zwischen Platte und TEG begünstigt, da weniger Lufteinschlüsse entstehen. Das steigert die Leistung der TEGs. Durch die gleichmäßige Wärmeverteilung werden Hotspots bzw. Temperaturunterschiede am einzelnen TEG reduziert, was ihre thermische Belastung mindert und so ihre Lebensdauer verlängern kann.

Die Wärmeverteilplatte muss kein separates Bauteil sein, sondern kann als Bestandteil einer umfassenderen Komponente bzw. eines komplexeren Bauteils ausgebildet sein.

Die Erfindung trägt direkt zur Erreichung der Klimaziele bei und hilft bei der Reduktion des Verbrauchs von Primärenergie.

Insbesondere kann vorgesehen sein, dass die Wärmeverteilplatte im oberen Drittel der vertikalen Erstreckung der Vorderseite des Heizkörpers angeordnet ist. Die Wärmeverteilplatte zumindest in jenem Bereich im oberen Drittel der vertikalen Erstreckung der Vorderseite des Heizkörpers angeordnet sein, der eine besondere thermische Nähe zu einem Vorlaufeingang des Heizkörpers aufweist.

Weiters kann vorgesehen sein, dass die Wärmeverteilplatte aus einem metallischen Werkstoff umfassend Aluminium mit einer Wandstärke zwischen 1 bis 8 mm, insbesondere 1,5 mm bis 4 mm, besteht. Es könnte auch Kupfer eingesetzt und/ oder hinzugefügt werden, ist allerdings aufgrund der höheren Materialkosten weniger wirtschaftlich. Beide Materialien haben einen deutlich höheren Wärmeleitwert als Stahl. Grundsätzlich sind Metalle oder Legierungen mit einem Wärmeleitwert von mindestens 160 W/mK wünschenswert.

Insbesondere kann vorgesehen sein, dass zumindest eine, vorzugsweise zwei oder mehr, Energiewandlungseinheiten auf einer Wärmeverteilplatte angeordnet sind. Durch gleichmäßige Wärmeverteilung zwischen einem oder mehreren TEGs werden Hotspots bzw. Temperaturunterschiede am einzelnen TEG reduziert, was ihre thermische Belastung mindert und so ihre Lebensdauer verlängern kann.

Weiters kann vorgesehen sein, dass alle Energiewandungseinheiten auf gleicher Höhe auf der Wärmeverteilplatte angeordnet sind. Abweichung von +-10mm werden als innerhalb der Toleranz betrachtet, um weiterhin als gleiche Höhe zu gelten.

Insbesondere kann vorgesehen sein, dass das Heizsystem mehrere Wärmeverteilplatten aufweist, die nebeneinander angeordnet sind.

Weiters kann vorgesehen sein, dass die Wärmeverteilplatte(n) so gewählt sind, dass sie in Summe zumindest 80% der horizontalen Erstreckung der Vorderseite des Heizkörpers abdecken/angreifen. Die Vorderseite des Heizkörpers ist also die den Raum zugewandte Seite.

Insbesondere kann vorgesehen sein, dass die horizontale Länge der Wärmeverteilplatte größer gleich der horizontalen Länge eines thermoelektrischen Generators ist, insbesondere zwischen 30 und 1000 mm, oder insbesondere zwischen 30 und 500 mm, und die vertikale Höhe zwischen 10 und 50 mm liegt.

Weiters kann vorgesehen sein, dass das Heizsystem zumindest ein Klemmmittel umfasst, die dazu eingerichtet sind, an einer von der Vorderseite des Heizkörpers abgewandten Eingriffsseite sowie an der zweiten Seite der Wärmeverteilplatte anzugreifen und die Wärmeverteilplatte gegen die Vorderseite des Heizkörpers mit einem definierten Anpressdruck festzuklemmen. Die Eingriffsseite ist bei einlagigen Heizkörpern die Rückseite des Heizkörpers, bei zweilagigen Heizkörpern kann es sich auch z.B. um eine Öffnung, die in der Mitte angeordnet sein kann, handeln. Durch den Einsatz von Wärmeplatten wird eine einfache mechanische Anbringung an Heizkörpern unterschiedlicher Bauart und Heizkörperoberfläche möglich, da die Energiewandlungseinheiten auf standardisierbaren Wärmeplatten angeordnet werden können. D.h. es können Wärmeplatten gleicher Bauart an unterschiedlichen Heizkörpern angebracht werden. Die Wärmeplatte kann Bohrungen und/oder andere Befestigungsvorbereitungen zur Fixierung des Kühlkörpers sowie der Energiewandlungseinheit aufweisen. Es ist auch eine Anpassung an Dicke des Aufbaus durch Anpassung der Klemmmittel, insbesondere in Form von Klammern möglich. Es können unterschiedliche Klammern vorgesehen sein, um an unterschiedliche Dickenbereiche anzupassen, z.B. eine Klammer für 50-70 mm, eine für 70 mm bis 100mm etc., wobei die Befestigung so ausgeführt ist, dass ein definierter Anpressdruck auf die Energiewandlungseinheit in Bezug auf die Wärmeplatte ausgeübt wird. Die Klammer kann aus Metall, insbesondere aus Stahl, hergestellt sein.

Insbesondere kann vorgesehen sein, dass die Klemmmittel im Wesentlichen U-förmig ausgebildet sind, sodass die Klemmmittel im montierten Zustand auf den Heizkörper an zwei Seiten, nämlich seiner Vorderseite und seiner Eingriffsseite mechanischen Anpressdruck ausüben. Der Ausdruck "von außen umgreifen" bedeutet hierbei, dass sich das Klemmmittel an der Vorder- und Rückseite des Heizkörpers abstützen kann und sich hierzu z.B. über die Oberseite des Heizkörpers erstreckt. U-förmig bedeutet, dass es eine Basis gibt, von der sich zwei Schenkel erstrecken. Diese Schenkel müssen nicht zwangsläufig gerade sein, sondern können günstiger Weise einen Bogen oder einen Knick zur Innenseite hin aufweisen, sodass sie an dem Heizkörper festgeklemmt werden können.

Weiters kann vorgesehen sein, dass die Wärmeverteilplatte eine Vertiefung, insbesondere eine horizontale Nut, aufweist, und das Klemmmittel einen hierzu korrespondierenden Vorsprung aufweist, der dazu eingerichtet ist, in die Vertiefung einzugreifen, sodass das Klemmmittel in einer definierten Position im montierten Zustand an der Wärmeverteilplatte klemmend fixiert ist. Der Vorsprung kann z.B. durch einen Knick in einem Schenkel des Klemmmittels ausgebildet sein. In Verbindung mit dem Eingriff in die Nut der Wärmeverteilplatte erfolgt dadurch eine Fixierung der Höhe der Wärmeleitplatte in Bezug auf den Heizkörper. Die Vertiefung dient dabei auch als Schablone zur Befestigung der Klemmmittel, die z.B. als Montagehaken ausgebildet sein können.

Insbesondere kann vorgesehen sein, dass die Wärmeverteilplatte Bohrung aufweist, mittels denen der Kühlkörper mechanisch an der Wärmeverteilplatte fixiert ist, wobei zwischen der Wärmeverteilplatte und dem Kühlkörper zumindest ein thermoelektrischer Generator angeordnet ist.

Weiters kann vorgesehen sein, dass je thermoelektrischen Generator zumindest zwei Öffnungen in der Wärmeverteilplatte, wobei der Kühlkörper korrespondierende Öffnungen mit Schraubgewinde aufweist, sodass dieser Mittels Schrauben mechanisch auf der Wärmeverteilplatte fixiert ist, wobei die Verschraubung ausgehend von der Wärmeverteilplatte hin zu dem Kühlkörper erfolgt. Diese Komponenten können somit auch vormontiert werden bzw. in vormontierter Form geliefert werden. Durch die Ausbildung als Schraubverbindung kann der Anpressdruck, mit dem das TEG auf die Wärmeverteilplatte gepresst wird, gezielt eingestellt werden, indem die Schrauben mit einem vorgebbaren Drehmoment angezogen werden.

Insbesondere kann vorgesehen sein, dass die Wärmeverteilplatte zur Montage vertikal abstehende Vorsprünge aufweist, in denen die Öffnungen angeordnet sind.

Weiters kann vorgesehen sein, dass an einer die Rückseite mit der Vorderseite verbindenden Unterseite des Heizkörpers eine Lüftungseinheit zur Erzeugung eines Luftstromes angeordnet ist, wobei die Energiewandlungseinheit unter Nutzung der durch den thermoelektrischen Generator erzeugbaren elektrischen Energie zur elektrischen Versorgung der Lüftungseinheit eingerichtet und mit der Lüftungseinheit elektrisch verbunden ist, wobei die Lüftungseinheit dergestalt ausgebildet ist, dass der durch die Lüftungseinheit erzeugbare Luftstrom zur Verbesserung der Konvektion des Heizkörpers auf den Heizkörper gerichtet ist. Wenn mehrere Energiewandlungseinheiten, dann können diese den Lüfter gemeinsam versorgen, oder es können auch mehrere Lüfter vorgesehen sein. Die Lüftungseinheit kann z.B. einen Querstromlüfter umfassen.

Die Erfindung ist im Folgenden anhand von beispielhaften und nicht einschränkenden Ausführungsformen näher erläutert, die in den Figuren veranschaulicht sind. Darin zeigt
Figur 1 eine schematische Darstellung eines Heizungskreislaufes, der ein beispielhaftes erfindungsgemäßes Heizsystem umfasst,
Figur 2 eine schematische Detailansicht eines Heizsystems gemäß einer Ausführungsform der Erfindung,
Figur 3 eine Vorderansicht auf die Ausführungsform gemäß Fig. 2, wobei darin auf der linken Seite die thermoelektrischen Generatoren ohne daran montierter Kühleinheit dargestellt sind,
Figur 4 eine perspektivische Darstellung auf die Ausführungsform gemäß Fig. 2 bis 3 von schräg oben,
Figur 5a einen Schnitt gemäß der Schnittlinie B-B aus Fig. 3,
Figur 5b einen Schnitt gemäß der Schnittlinie A-A aus Fig. 3,
Figur 5c ein Detail C aus Fig. 5b, und
Figur 6 eine beispielhafte Ausführung einer Wärmeverteilplatte.

In den folgenden Figuren bezeichnen - sofern nicht anders angegeben - gleiche Bezugszeichen gleiche Merkmale.

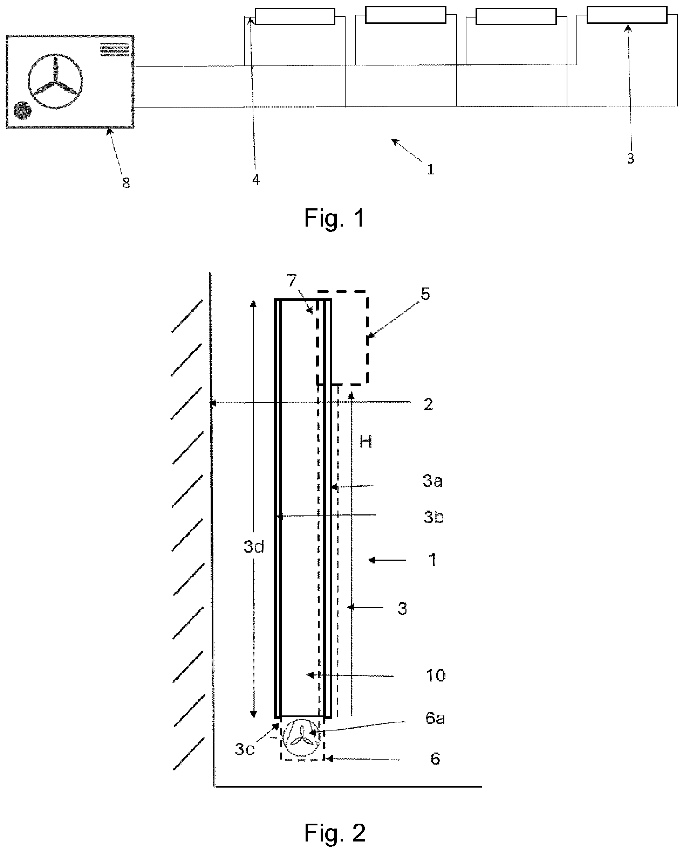

**Fig. 1** zeigt schematische Darstellung eines Heizungskreislaufes, der ein beispielhaftes erfindungsgemäßes Heizsystem 1 umfasst. Darin weist das Heizsystem 1 vier Heizkörper 3 auf. Zudem weist das Heizsystem 1 eine Wärmepumpe 8 als Energiequelle auf, die mit den Heizkörpern 3 thermisch gekoppelt ist, indem die Wärmepumpe 8 dazu eingerichtet ist, Wärmeenergie in das Fluid 4, das zur Zirkulation in dem Heizkörper 3 vorgesehen ist, einzubringen.

**Fig. 2** zeigt eine schematische Detailansicht eines Heizsystems 1 gemäß einer Ausführungsform der Erfindung. Das Heizsystem 1 umfasst zumindest einen an einer Gebäudewand 2 montierten Heizkörper 3 zur Führung eines Fluids 4, insbesondere Heizwassers, wobei der Heizkörper 3 eine im Wesentlichen vertikal orientierte Vorderseite 3a sowie eine der Vorderseite 3a abgewandte vertikal orientierte Rückseite 3b aufweist. Die Rückseite 3b ist der Gebäudewand 2 zugewandt ist. An der Oberfläche des Heizkörpers 3 ist zumindest eine Energiewandlungseinheit 5 angeordnet. Es kann vorgesehen sein, dass der Heizkörper 3 zumindest eine zwischen seiner Vorderseite 3a seiner Rückseite 3b angeordnete vertikal orientierte Öffnung 10 zur Vergrößerung seiner Wärmeaustauschfläche aufweist. Ein durch eine Lüftungseinheit 6 (z.B. als Querstromlüfter oder als Radiallüfter ausgebildet sein kann) erzeugbarer Luftstrom kann z.B. überwiegend in diese Öffnung 10 gelenkt sein. An einer die Rückseite 3b mit der Vorderseite 3a verbindenden Unterseite 3c des Heizkörpers 3 ist eine Lüftungseinheit 6 zur Erzeugung eines Luftstromes angeordnet, die insbesondere als Querstromlüfter 6a ausgebildet sein kann, wobei die Energiewandlungseinheit 5 unter Nutzung der durch den thermoelektrischen Generator 5b erzeugbaren elektrischen Energie zur elektrischen Versorgung der Lüftungseinheit 6 eingerichtet und mit der Lüftungseinheit 6 elektrisch verbunden ist, wobei die Lüftungseinheit 6 dergestalt ausgebildet ist, dass der durch die Lüftungseinheit 6 erzeugbare Luftstrom zur Verbesserung der Konvektion des Heizkörpers 3 auf den Heizkörper 3 gerichtet ist.

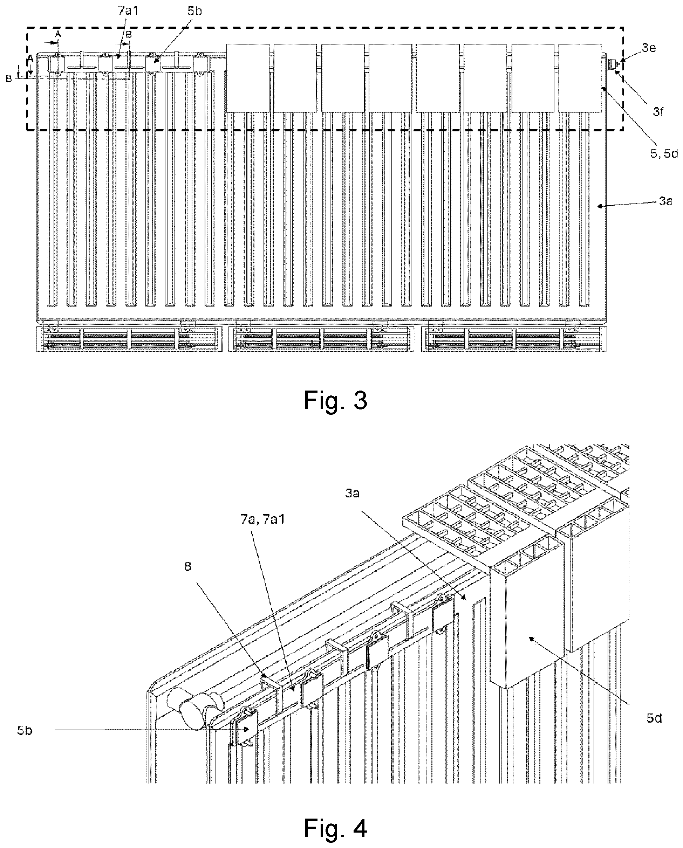

**Fig. 3** zeigt eine Vorderansicht auf die Ausführungsform gemäß **Fig. 2**, wobei darin auf der linken Seite thermoelektrischen Generatoren 5b der Energiewandlungseinheit zur besseren Übersicht ohne daran montiertem Kühlkörper 5d dargestellt sind. In der Praxis wird daran natürlich ein Kühlkörper 5d montiert sein. Der Heizkörper 3 weist ein Zulaufrohr 3f mit rundem Querschnitt mit einer Zulauföffnung 3e zur Zufuhr des Fluids 4 (siehe **Fig. 1**) auf.

**Fig. 4** zeigt eine perspektivische Darstellung auf die Ausführungsform gemäß **Fig. 2 bis 3** von schräg oben. Es sind darin beispielhaft zwölf Energiewandlungseinheiten 5 zu sehen, wobei zur besseren Übersicht bei den linken vier Einheiten bloß die Generatoren 5b dargestellt sind. Zudem ist darin die Wärmeverteilplatte 7a sowie Klemmmittel 8, mit denen die Wärmeverteilplatte an dem Heizkörper 3 gehalten wird, deutlich erkennbar. Vorliegend hat der Heizkörper eine Öffnung 10, wie sie mit Blick auf **Fig. 1** erwähnt ist, wobei die Klemmmittel 8 an der vorderseitigen Wärmeverteilplatte 7a sowie innerhalb der Öffnung 10 angreifen und so die Wärmeverteilplatte 7a gegen die Vorderseite 3a drücken und fixieren.

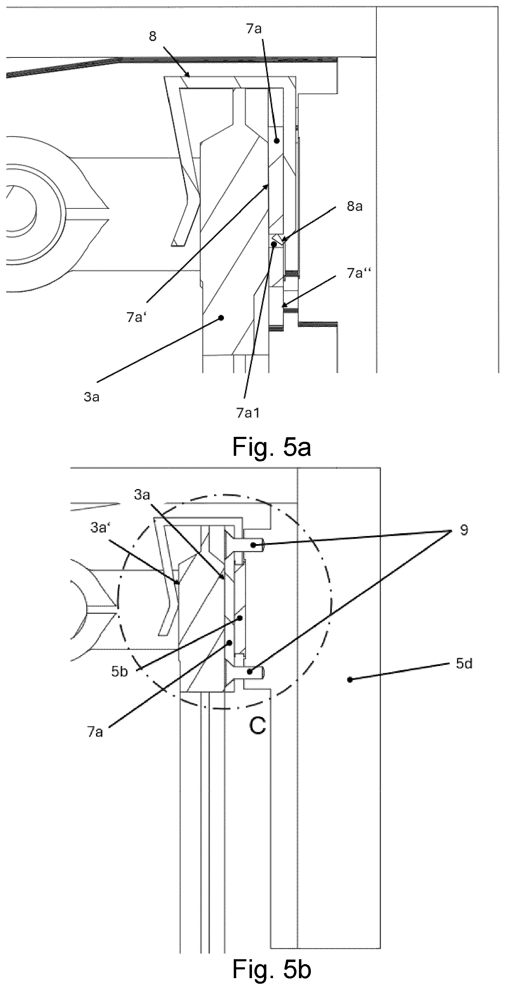

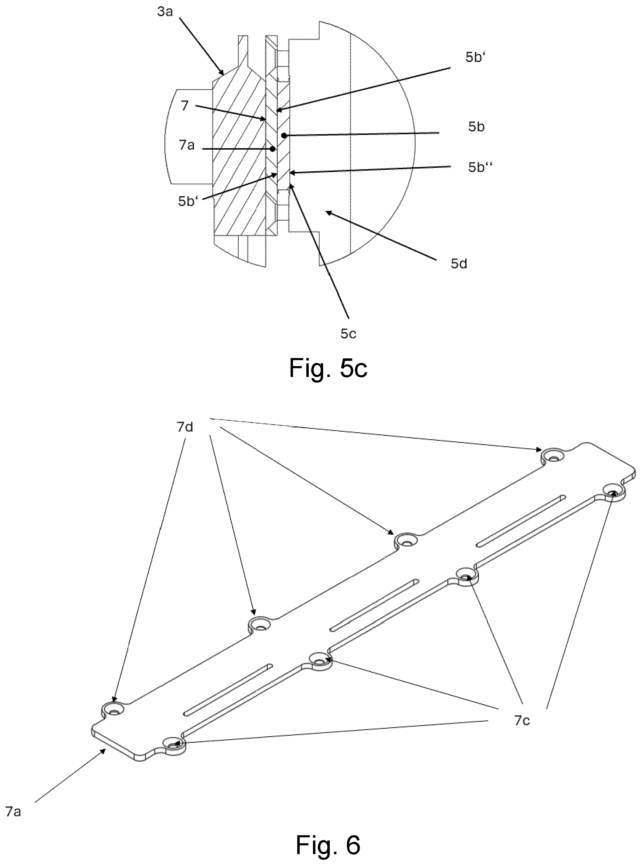

**Fig. 5a** zeigt einen Schnitt gemäß der Schnittlinie A-A aus **Fig. 3****,** **Fig. 5b** zeigt einen Schnitt gemäß der Schnittlinie A-A aus **Fig. 3** und **Fig. 5c** zeigt ein Detail C aus **Fig. 5b****.** Mit Blick auf die beiden **Figuren 5a und 5b** sei erwähnt, dass die thermoelektrischen Generatoren 5b jeweils eine erste Kontaktfläche 5b' und eine gegenüberliegenden zweiten Kontaktfläche 5b" aufweisen, wobei die zumindest eine Energiewandlungseinheit 5 einen zur Luftdurchströmung eingerichteten Kühlkörper 5d aufweist, der mit der zweiten Kontaktfläche 5b" des thermoelektrischen Generators 5b über eine zweite flächige Wärmeleitverbindung 5c thermisch verbunden ist, um einen Wärmeaustausch der zweiten Kontaktfläche 5b" mit der Umgebungsluft des Kühlkörpers 5d zu ermöglichen.

Die erste Kontaktfläche 5b' des thermoelektrischen Generators 5b verfügt über eine erste flächige Wärmeleitverbindung 7 mit dem Heizkörper 3 in thermischen Kontakt steht, sodass durch den thermoelektrischen Generator 5b eine Temperaturdifferenz zwischen der ersten Kontaktfläche 5b' und der zweiten Kontaktfläche 5b" unter Ausnutzung des Seebeck-Effekts in elektrische Energie wandelbar ist. Erfindungsgemäß weist die erste flächige Wärmeleitverbindung 7 eine metallische Wärmeverteilplatte 7a auf, die mit einer ersten Seite 7a' flächig an der Vorderseite 3a des Heizkörpers 3 angeordnet ist, wobei durch eine der ersten Seite 7a' gegenüberliegenden zweiten Seite 7a" der Wärmeverteilplatte 7a ein von der Vorderseite 3a des Heizkörpers 3 abgewandter ebener Wärmeleitbereich 7a1 ausbildet wird, wobei die erste Kontaktfläche 5b' des thermoelektrischen Generators 5b die Wärmeverteilplatte 7a an der zweiten Seite 7a" an dem Wärmeleitbereich 7a1 thermisch kontaktiert. Es ist vorgesehen, dass die erste Kontaktfläche 5b' des thermoelektrischen Generators 5b die Fläche der zweiten Seite 7a" der Wärmeverteilplatte 7a flächig kontaktiert, wobei Fläche der Wärmeverteilplatte 7a größer ist als die erste Kontaktfläche 5b' des thermoelektrischen Generators 5b.

In **Fig. 2** **und** **3** ist erkennbar, dass die Wärmeverteilplatte 7a im oberen Drittel der vertikalen Erstreckung 3d der Vorderseite 3a des Heizkörpers 3 angeordnet ist. Dabei kann vorgesehen sein, dass die Wärmeverteilplatte 7a zumindest in jenem Bereich im oberen Drittel der vertikalen Erstreckung 3d der Vorderseite 3a des Heizkörpers 3 angeordnet ist, der eine thermische Nähe zu einem Vorlaufeingang 3e des Heizkörpers 3 aufweist.

Die Wärmeverteilplatte 7a kann aus einem metallischen Werkstoff umfassend Aluminium mit einer Wandstärke zwischen 1 bis 8 mm, insbesondere 1,5 mm bis 4 mm, bestehen. **In** **Fig. 3 und 4** ist erkennbar, dass zwei oder mehr Energiewandlungseinheiten 5 auf einer Wärmeverteilplatte 7a angeordnet sein können. Durch eine gleichmäßige Wärmeverteilung werden Hotspots bzw. Temperaturunterschiede am einzelnen TEG reduziert, was ihre thermische Belastung mindert und so ihre Lebensdauer verlängern kann.

Es kann vorgesehen sein, dass alle Energiewandungseinheiten 5 auf gleicher Höhe H (siehe **Fig. 2**) auf der Wärmeverteilplatte 7a angeordnet sind. **Fig. 6** zeigt eine beispielhafte Ausführung einer Wärmeverteilplatte 7a. Es kann vorgesehen sein, dass das Heizsystem 1 mehrere Wärmeverteilplatten 7a aufweist, die nebeneinander angeordnet sind. Es kann aber auch vorgesehen sein, dass die Wärmeverteilplatten so gewählt sind, dass sie in Summe zumindest 80% der horizontalen Erstreckung der Vorderseite des Heizkörpers 3 abdecken/ angreifen.

Typischerweise kann die horizontale Länge der Wärmeverteilplatte größer/gleich der horizontalen Länge eines thermoelektrischen Generators 5b sein, insbesondere zwischen 30 und 1000 mm, oder insbesondere zwischen 30 und 500 mm, und die vertikale Höhe zwischen 10 und 50 mm liegt.

In **Fig. 4** ist gut erkennbar, dass das Heizsystem 1 zumindest ein Klemmmittel 8 umfasst, wobei die Klemmmittel 8 dazu eingerichtet sind, an einer von der Vorderseite 3a des Heizkörpers 3 abgewandten Eingriffsseite sowie an der zweiten Seite 7a" der Wärmeverteilplatte 7a anzugreifen und die Wärmeverteilplatte 7a gegen die Vorderseite 3a des Heizkörpers 3a mit einem definierten Anpressdruck festzuklemmen.

Die Eingriffsseite ist bei einlagigen Heizkörpern die Rückseite des Heizkörpers, bei zweilagigen Heizkörpern kann es sich auch z.B. um eine Öffnung 10 (siehe Fig. 2), die in der Mitte des Heizkörpers angeordnet ist, handeln.

Mit Blick auf **Fig. 5a** sei erwähnt, dass die Klemmmittel 8 im Wesentlichen U-förmig ausgebildet sind, sodass die Klemmmittel 8 im montierten Zustand auf den Heizkörper 3 an zwei Seiten, nämlich seiner Vorderseite 3a und seiner abgewandten Eingriffsseite 3a' mechanischen Anpressdruck ausüben. Dabei ist zumindest einer der zwei im Wesentlichen vertikal nach unten orientierten Schenkel, die von einer gemeinsamen Basis abstehen, etwas nach Innen gekrümmt bzw. weist einen Knick bzw. Vorsprung auf. Konkret kann z.B. vorgesehen sein, dass die Wärmeverteilplatte 7a eine Vertiefung 7a1, insbesondere eine horizontale Nut, aufweist, und das Klemmmittel 8 einen hierzu korrespondierenden Vorsprung 8a aufweist, der dazu eingerichtet ist, in die Vertiefung 7a1 einzugreifen, sodass das Klemmmittel 8 in einer definierten Position im montierten Zustand an der Wärmeverteilplatte klemmend fixiert ist.

**Fig. 5c** zeigt einen Schnitt gemäß der Schnittlinie A-A aus **Fig. 3**. In Zusammenschau mit **Fig. 6** ist erkennbar, dass die Wärmeverteilplatte 7a Bohrungen 7c aufweist, mittels denen der Kühlkörper 5d mechanisch an der Wärmeverteilplatte 7a fixiert ist, wobei zwischen der Wärmeverteilplatte 7a und dem Kühlkörper 5d zumindest ein thermoelektrischer Generator 5b angeordnet ist. Die Wärmeverteilplatte 7a zur Montage vertikal abstehende Vorsprünge 7d auf, in denen die Öffnungen 7c angeordnet sind.

Mit Blick auf **Fig. 5b** sei erwähnt, dass es vorgesehen sein kann, dass je thermoelektrischen Generator 5b zumindest zwei Öffnungen 7c in der Wärmeverteilplatte 7a vorhanden sind, wobei der Kühlkörper 5d korrespondierende Öffnungen mit Schraubgewinde aufweist, sodass dieser Mittels Schrauben 9 mechanisch auf der Wärmeverteilplatte 7a fixiert ist, wobei die Verschraubung ausgehend von der Wärmeverteilplatte 7a hin zu dem Kühlkörper 5d erfolgt. Das Heizsystem 1 kann somit zumindest teilweise vormontiert werden, wodurch eine raschere Installation beim Kunden möglich ist, und die Fehlerwahrscheinlichkeit reduziert wird.

Die Erfindung ist nicht auf die gezeigten Ausführungsformen beschränkt, sondern durch den gesamten Schutzumfang der Ansprüche definiert. Auch können einzelne Aspekte der Erfindung bzw. der Ausführungsformen aufgegriffen und miteinander kombiniert werden. Etwaige Bezugszeichen in den Ansprüchen sind beispielhaft und dienen nur der einfacheren Lesbarkeit der Ansprüche, ohne diese einzuschränken.

### Bezugszeichenliste

**1** Heizsystem
**2** Gebäudewand
**3** Heizkörper
   **3a** Vorderseite des Heizkörpers
   3a' von Vorderseite abgewandte Eingriffsseite des Heizkörpers
   **3b** Rückseite des Heizkörpers
   **3c** Unterseite des Heizkörpers
   **3d** Vertikale Erstreckung der Vorderseite des Heizkörpers
   **3e** Zulauföffnung
   **3f** Zulaufrohr
**4** Fluid (z. B. Heizwasser)
**5** Energiewandlungseinheit
   **5b** Thermoelektrischer Generator
      **5b'** Erste Kontaktfläche des thermoelektrischen Generators
      **5b"** Zweite Kontaktfläche des thermoelektrischen Generators
   **5c** Zweite flächige Wärmeleitverbindung
   **5d** Kühlkörper
**6** Lüftungseinheit
**7** Erste flächige Wärmeleitverbindung
   **7a** Metallische Wärmeverteilplatte
   **7a'** Erste Seite der Wärmeverteilplatte
   **7a"** Zweite Seite der Wärmeverteilplatte
   **7a1** Ebener Wärmeleitbereich bzw. Horizontale Nut bzw. Vertiefung
   **7c** Bohrung bzw. Öffnungen in der Wärmeverteilplatte
   **7d** Vertikal abstehende Vorsprünge der Wärmeverteilplatte
**8** Klemmmittel
   **8a** Vorsprung
**9** Schrauben
**10** Öffnung 10 im Heizkörper 3
**H** Höhe (Anordnungsebene der Energiewandlungseinheiten)

## Patentansprüche

1. **Heizsystem (1),** umfassend zumindest einen an einer Gebäudewand (2) montierten Heizkörper (3) zur Führung eines Fluids (4), insbesondere Heizwassers, wobei der Heizkörper (3) eine im Wesentlichen vertikal orientierte Vorderseite (3a) sowie eine der Vorderseite (3a) abgewandte vertikal orientierte Rückseite (3b) aufweist, wobei die Rückseite (3b) der Gebäudewand (2) zugewandt ist, wobei an der Oberfläche des Heizkörpers (3) zumindest eine Energiewandlungseinheit (5) angeordnet ist, wobei die zumindest eine Energiewandlungseinheit (5) einen thermoelektrischen Generator (5b) mit einer ersten Kontaktfläche (5b') und einer gegenüberliegenden zweiten Kontaktfläche (5b") aufweist, wobei die zumindest eine Energiewandlungseinheit (5) einen zur Luftdurchströmung eingerichteten Kühlkörper (5d) aufweist, der mit der zweiten Kontaktfläche (5b") des thermoelektrischen Generators (5b) über eine zweite flächige Wärmeleitverbindung (5c) thermisch verbunden ist, um einen Wärmeaustausch der zweiten Kontaktfläche (5b") mit der Umgebungsluft des Kühlkörpers (5d) zu ermöglichen, wobei die erste Kontaktfläche (5b') des thermoelektrischen Generators (5b) über eine erste flächige Wärmeleitverbindung (7) mit dem Heizkörper (3) in thermischen Kontakt steht, sodass durch den thermoelektrischen Generator (5b) eine Temperaturdifferenz zwischen der ersten Kontaktfläche (5b') und der zweiten Kontaktfläche (5b") unter Ausnutzung des Seebeck-Effekts in elektrische Energie wandelbar ist,
**dadurch gekennzeichnet, dass**
die erste flächige Wärmeleitverbindung (7) eine metallische Wärmeverteilplatte (7a) aufweist, die mit einer ersten Seite (7a') flächig an der Vorderseite (3a) des Heizkörpers (3) angeordnet ist, wobei durch eine der ersten Seite (7a') gegenüberliegenden zweiten Seite (7a") der Wärmeverteilplatte (7a) ein von der Vorderseite (3a) des Heizkörpers (3) abgewandter ebener Wärmeleitbereich (7a1) ausbildet wird, wobei die erste Kontaktfläche (5b') des thermoelektrischen Generators (5b) die Wärmeverteilplatte (7a) an der zweiten Seite (7a") an dem Wärmeleitbereich (7a1) thermisch kontaktiert, wobei die erste Kontaktfläche (5b') des thermoelektrischen Generators (5b) die Fläche der zweiten Seite (7a") der Wärmeverteilplatte (7a) flächig kontaktiert, wobei Fläche der Wärmeverteilplatte (7a) größer ist als die erste Kontaktfläche (5b') des thermoelektrischen Generators (5b).

2. Heizsystem (1) nach Anspruch 1, wobei die Wärmeverteilplatte (7a) im oberen Drittel der vertikalen Erstreckung (3d) der Vorderseite (3a) des Heizkörpers (3) angeordnet ist.

3. Heizsystem (1) nach einem der vorhergehenden Ansprüche, wobei die Wärmeverteilplatte (7a) aus einem metallischen Werkstoff umfassend Aluminium mit einer Wandstärke zwischen 1 bis 8 mm, insbesondere 1,5 mm bis 4 mm, besteht.

4. Heizsystem (1) nach einem der vorhergehenden Ansprüche, wobei zumindest eine, vorzugsweise zwei oder mehr, Energiewandlungseinheiten (5) auf einer Wärmeverteilplatte (7a) angeordnet sind.

5. Heizsystem (1) nach einem der vorhergehenden Ansprüche, wobei alle Energiewandungseinheiten (5) auf gleicher Höhe (H) auf der Wärmeverteilplatte (7a) angeordnet sind.

6. Heizsystem (1) nach einem der vorhergehenden Ansprüche, wobei das Heizsystem (1) mehrere Wärmeverteilplatten (7a) aufweist, die nebeneinander angeordnet sind.

7. Heizsystem (1) nach einem der Ansprüche 1 bis 5, wobei die Wärmeverteilplatte(n) so gewählt sind, dass sie in Summe zumindest 80% der horizontalen Erstreckung der Vorderseite des Heizkörpers (3) abdecken/angreifen.

8. Heizsystem (1) nach einem der vorhergehenden Ansprüche, wobei die horizontale Länge der Wärmeverteilplatte größer gleich der horizontalen Länge eines thermoelektrischen Generators ist (7a) insbesondere zwischen 30 und 1000 mm, oder insbesondere zwischen 30 und 500 mm, und die vertikale Höhe zwischen 10 und 50 mm liegt.

9. Heizsystem (1) nach einem der vorhergehenden Ansprüche, wobei das Heizsystem (1) zumindest ein Klemmmittel (8) umfasst, das dazu eingerichtet ist, an einer von der Vorderseite (3a) des Heizkörpers (3) abgewandten Eingriffsseite (3a') sowie an der zweiten Seite (7a") der Wärmeverteilplatte (7a) anzugreifen und die Wärmeverteilplatte (7a) gegen die Vorderseite (3a) des Heizkörpers (3a) mit einem definierten Anpressdruck festzuklemmen.

10. Heizsystem (1) nach Anspruch 9, wobei die Klemmmittel (8) im Wesentlichen U-förmig ausgebildet sind, sodass die Klemmmittel (8) im montierten Zustand auf den Heizkörper (3) an zwei Seiten, nämlich seiner Vorderseite (3a) und seiner Eingriffsseite () mechanischen Anpressdruck ausüben.

11. Heizsystem (1) nach Anspruch 10 oder 11, wobei die Wärmeverteilplatte (7a) eine Vertiefung (7a1), insbesondere eine horizontale Nut, aufweist, und das Klemmmittel (8) einen hierzu korrespondierenden Vorsprung (8a) aufweist, der dazu eingerichtet ist, in die Vertiefung (7a1) einzugreifen, sodass das Klemmmittel (8) in einer definierten Position im montierten Zustand an der Wärmeverteilplatte klemmend fixiert ist.

12. Heizsystem (1) nach einem der vorhergehenden Ansprüche, wobei die Wärmeverteilplatte (7a) zumindest eine Bohrung (7c) aufweist, mittels denen der Kühlkörper (5d) mechanisch an der Wärmeverteilplatte (7a) fixiert ist, wobei zwischen der Wärmeverteilplatte (7a) und dem Kühlkörper (5d) zumindest ein thermoelektrischer Generator (5b) angeordnet ist.

13. Heizsystem (1) nach Anspruch 12, wobei je thermoelektrischen Generator (5b) zumindest zwei Öffnungen (7c) in der Wärmeverteilplatte (7a), wobei der Kühlkörper (5d) korrespondierende Öffnungen mit Schraubgewinde aufweist, sodass dieser Mittels Schrauben (9) mechanisch auf der Wärmeverteilplatte (7a) fixiert ist, wobei die Verschraubung ausgehend von der Wärmeverteilplatte (7a) hin zu dem Kühlkörper (5d) erfolgt.

14. Heizsystem (1) nach einem der vorhergehenden Ansprüche, wobei die Wärmeverteilplatte (7a) zur Montage vertikal abstehende Vorsprünge (7d) aufweist, in denen die Öffnungen (7c) angeordnet sind.

15. Heizsystem (1) nach einem der vorhergehenden Ansprüche, wobei an einer die Rückseite (3b) mit der Vorderseite (3a) verbindenden Unterseite (3c) des Heizkörpers (3) eine Lüftungseinheit (6) zur Erzeugung eines Luftstromes angeordnet ist, wobei die Energiewandlungseinheit (5) unter Nutzung der durch den thermoelektrischen Generator (5b) erzeugbaren elektrischen Energie zur elektrischen Versorgung der Lüftungseinheit (6) eingerichtet und mit der Lüftungseinheit (6) elektrisch verbunden ist, wobei die Lüftungseinheit (6) dergestalt ausgebildet ist, dass der durch die Lüftungseinheit (6) erzeugbare Luftstrom zur Verbesserung der Konvektion des Heizkörpers (3) auf den Heizkörper (3) gerichtet ist.
